# EUROPEAN PATENT SPECIFICATION

(11) **EP 3 522 692 B1**
(45) Date of publication and mention of the grant of the patent: **27.10.2021**
(21) Application number: 16917698.9
(22) Date of filing: 29.09.2016
(51) Int. Cl.: H05K 13/04, H05K 13/08

(54) **MOUNTING DEVICE AND MOUNTING METHOD**
MONTAGEVORRICHTUNG UND MONTAGEVERFAHREN
DISPOSITIF DE MONTAGE ET PROCÉDÉ DE MONTAGE

(43) Date of publication of application: 07.08.2019
(73) Proprietor: Fuji Corporation, Chiryu-shi, Aichi 472-8686 (JP)
(72) Inventor: MIYAZAKI, Shingo, Chiryu Aichi (JP)
(74) Representative: Grünecker Patent- und Rechtsanwälte PartG mbB
(86) International application number: PCT/JP2016/078821
(87) International publication number: WO 2018/061146

(56) References cited:
- EP-A1- 2 981 163
- JP-A- H05 104 349
- JP-A- 2014 099 446

## Description

### Technical field

The present invention relates to a mounting device and a mounting method.

### Background Art

Conventionally, there has been known a mounting device for mounting a component on a board by driving a motor to lower a suction nozzle holding the component (for example, refer to Patent Literature 1). In this mounting device, a dedicated pressure sensor is provided which is configured to detect the force applied to the suction nozzle, and the peak value of the force detected by the pressure sensor when mounting the component is analyzed to determine an appropriate descending speed at which the peak value falls within a permissible limit. Then, the mounting device lowers the suction nozzle at the determined descending speed to mount the component on the board, thereby preventing the component from being damaged.

Patent Literature 2 discloses the preamble of claim 1.

### Patent Literature

Patent Literature 1: JP-A-2001-57498
Patent Literature 2: EP 2 981 163 A1

### Summary of Invention

### Technical Problem

However, the mounting device described in Patent Literature 1 needs the dedicated pressure sensor configured to detect the force applied to the suction nozzle. This not only requires ensuring a space for installing the pressure sensor but also increases the production costs.

The main object of the present invention is to set an appropriate descending speed of the suction nozzle without using a dedicated sensor.

### Solution to Problem

To achieve the main object, the present invention provides the following manners.

In the present invention, a mounting device according to claim 1 is provided.

The mounting device of the invention acquires, based on the driving state of the motor necessary for the feedback control, at least one of the load resulting when the pickup member descends to the supply position of the pickup target component to come into contact the pickup target component, and the load resulting when the pickup member descends to the mounting position of the component in the picked-up state to come into contact with the board via the component. Then, the mounting device determines at least one of the descending speed at which the pickup member descends to the supply position and the descending speed of the pickup member when descending to the mounting position based on the acquired load. By adopting the configuration described above, an appropriate descending speed of the pickup member can be determined by using the driving state of the motor that is detected through the feedback control without providing a dedicated sensor.

In the mounting device of the present invention, wherein, until the determination section determines the descending speed, the pickup member is lowered at a predetermined low speed, wherein the acquisition section is configured to acquire the load based on the driving state when the pickup member is lowered at the predetermined low speed, and wherein the determination section is configured to determine the descending speed to be faster than the predetermined low speed in a case where the load acquired by the acquisition section is low in comparison with a case where the load is high. Impact force generated when the pickup member comes into contact with the component or the board can be suppressed by lowering the pickup member at the predetermined low speed until the descending speed is determined. Further, in the case where the acquired load is low, when compared with the case where the load is high, the pickup member is allowed to descend quickly to improve the efficiency of the pickup process or the mounting process while suppressing the impact force to an appropriate level by determining the descending speed that tends to be faster than the predetermined low speed.

In the mounting device of the present invention, the acquisition section may be configured to acquire the load in association with a type of component, and the determination section may be configured to determine the descending speed for each type of component. By doing so, the suction member can be lowered at an appropriate descending speed for each type of component.

In the mounting device of the present invention, the acquisition section is configured to acquire the load in association with multiple regions of the board, and the determination section is configured to determine the descending speed when descending to the mounting position for each of the multiple regions. By doing so, the pickup member can be lowered to the mounting position at an appropriate descending speed for each of the multiple regions of the board.

The mounting device of the present invention may comprise multiple types of supply devices having different supply methods of supplying the component, the acquisition section may be configured to acquire the load in association with the types of the supply devices, and the determination section may be configured to determine the descending speed when descending to the supply position for each of the types of supply devices. By doing so, the pickup member can be lowered to the supply position at the appropriate descending speed according to the supply method of the supply device.

According to the the present invention, there is provided a mounting method for mounting a component on a board using a pickup member configured to be lifted or lowered by driving a motor with feedback control to pick up the component, comprising: (a) a step of acquiring, based on a driving state of the motor detected in the feedback control; at least one of a load resulting when the pickup member descends to a supply position of a pickup target component to come into contact with the pickup target component and a load resulting when the pickup member descends to a mounting position of the component in a picked up state to come into contact with the board via the component, and (b) a step of determining, based on the load acquired in the step (a), at least one of a descending speed of the pickup member when descending to the supply position and a descending speed of the pickup member when descending to the mounting position, wherein the load is acquired in association with multiple regions of the board, and
the descending speed is determined when descending to the mounting position for each of the multiple regions.

With the mounting method of the present invention, as with the mounting device described above, it is possible to determine appropriate descending speeds of the pickup member by using the driving state of the motor detected in the feedback control without requiring the detection of a load using a dedicated sensor. In this mounting method, steps for achieving various aspects of the mounting device described above may be added.

### Brief Description of Drawings

Fig. 1 is a block diagram illustrating a schematic configuration of mounting device 10.
Fig. 2 is a block diagram illustrating electrical connections of the mounting device 10.
Figs. 3(a) and (b) are explanatory diagrams showing the descending speed of pickup nozzle 54 and a drive current of Z-axis motor 55, respectively.
Fig. 4 is a flowchart illustrating an example of a mounting process.
Fig. 5 is a flowchart illustrating an example of a load acquisition process.
Figs. 6(a) and (b) are diagrams illustrating a change in load L.
Fig. 7 is a flowchart illustrating an example of a descending speed determination process.
Fig. 8 is a diagram illustrating an example of division of regions of substrate S.
Fig. 9 is a flowchart illustrating a load acquisition process at the time of mounting according to a modified example.
Fig. 10 is a flowchart illustrating a descending speed determining process at the time of mounting according to the modified example.
Fig. 11 is a flowchart illustrating a load acquisition process at the time of pickup according to the modified example.
Fig. 12 is a flowchart illustrating a descending speed determination process at the time of pickup according to the modified example.

### Description of Embodiment

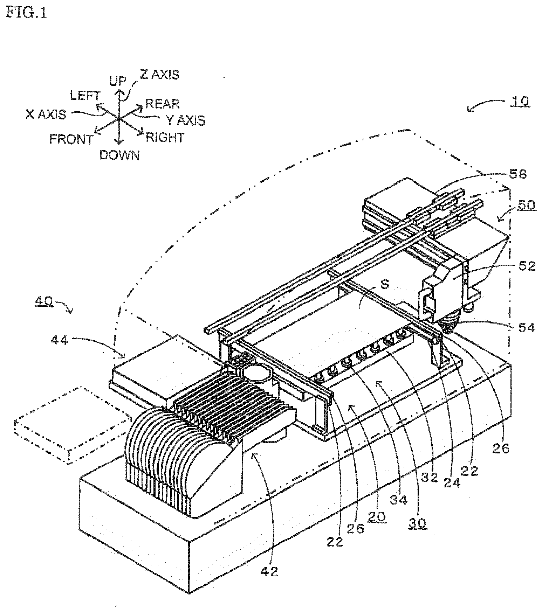

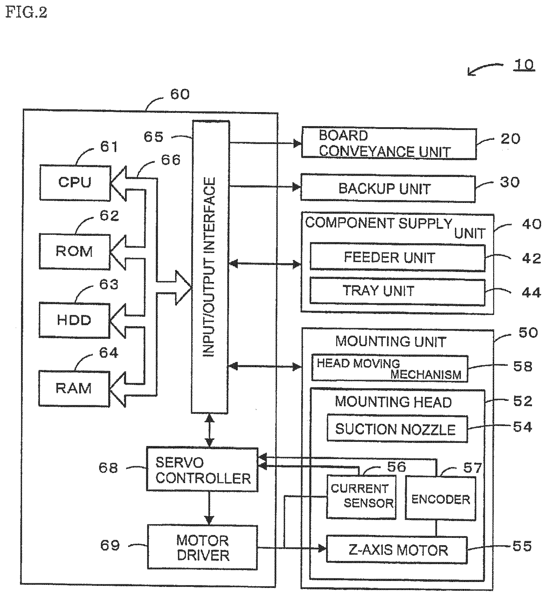

Fig. 1 is a block diagram illustrating a schematic configuration of mounting device 10, and Fig. 2 is a block diagram illustrating electrical connections of the mounting device 10. In Fig. 1, the left-right direction constitutes the X-axis direction, the front-rear direction constitutes the Y-axis direction, and the up-down direction constitutes the Z-axis direction.

Mounting device 10 is a device configured to perform a mounting process for mounting a component on board S and includes board conveyance unit 20, backup unit 30, component supply unit 40, mounting unit 50, and control device 60, as illustrated in Figs. 1 and 2.

As illustrated in FIG. 1, board conveyance unit 20 includes a pair of side frames 22 disposed to be spaced apart from each other in the Y-axis direction with a predetermined space defined therebetween and conveyor belts 24 provided separately on the pair of side frames 22, and board S is conveyed by driving conveyor belts 24 circumferentially. Further, although not shown, board conveyance unit 20 includes a clamper that can be lifted and lowered, and with board S accommodated on conveyor belts 24, the clamper is lifted to push up board S, whereby board S is pressed against fastening sections 26 at upper ends of side frames 22. This allows board S to be held between the clamper and fastening sections 26 to be clamped thereat.

Backup unit 30 includes backup plate 32 installed so as to be lifted up and down by a lifting and lowering device, not shown, and multiple backup pins 34 erected on backup plate 32. Backup unit 30 raises backup plate 32 with board S conveyed by board conveyance unit 20 kept clamped so that board S is backed up by backup pins 34 from the rear surface thereof.

Component supply unit 40 includes feeder unit 42 and tray unit 44. Feeder unit 42 supplies components to a supply position by feeding out, with a feeder, a carrier tape accommodating multiple components from a reel around which the carrier tape is wound. The carrier tape includes a bottom tape made of paper or the like and having component accommodating sections formed thereon at predetermined intervals and a top film covering the front surface of the bottom tape and configured to be separated before the supply position. Tray unit 44 supplies components to the supply position by placing components in multiple rows.

Mounting unit 50 picks up components supplied from component supply unit 40 and mounts them on board S. Mounting unit 50 includes mounting head 52 and head moving mechanism 58. Head moving mechanism 58 includes a slider moving in the XY direction by being guided by guide rails and a motor configured to drive the slider. Mounting head 52 is detachably mounted on the slider of head moving mechanism 58 and is caused to move in the XY direction by head moving mechanism 58. Suction nozzles 54 of one or more types may be detachably mounted on the lower surface of mounting head 52, and suction nozzles 54 matching the component types may be mounted thereon. Suction nozzle 54 is a suction member configured to pick up a component by using pressure. Mounting head 52 lifts and lowers suction nozzle 54 in the Z direction using a lifting and lowering device (a Z-axis slider), being not shown, of which driving source is Z-axis motor 55 as a servomotor. Mounting head 52 rotates suction nozzle 54 (on its own axis) using a motor, not shown, so as to adjust the angle of a component picked up by suction nozzle 54.

As illustrated in Fig. 2, control device 60 is configured as a microprocessor operated mainly by CPU 61 and includes ROM 62 storing process programs, HDD 63 storing various types of data, RAM 64 used as a working region, input/output interface 65 configured to exchange electric signals with an external device, and the like, which are connected together by way of bus 66. Control device 60 outputs a control signal to board conveyance unit 20, a control signal to backup unit 30, a control signal to component supply unit 40, a control signal to head moving mechanism 58, a control signal to suction nozzle 54, a control signal to servo controller 68 configured to feedback control Z-axis motor 55, and the like. Control device 60 receives several signals as input signals, including a signal indicating that a component is supplied to the supply position from component supply unit 40, a position signal from a position sensor, not shown, configured to detect the position of the slider of head moving mechanism 58, a position signal from a position sensor, not shown, configured to detect the position of the lifting and lowering device (the Z-axis slider) that is driven by Z-axis motor 55, and the like. Servo controller 68 receives the current value from current sensor 56 configured to detect the drive current supplied to Z-axis motor 55, positional information from encoder (rotary encoder) 57 configured to detect a rotational position of a rotor of Z-axis motor 55, and the like. Servo controller 68 also receives a speed command for suction nozzle 54 (the Z-axis slider) from CPU 61.

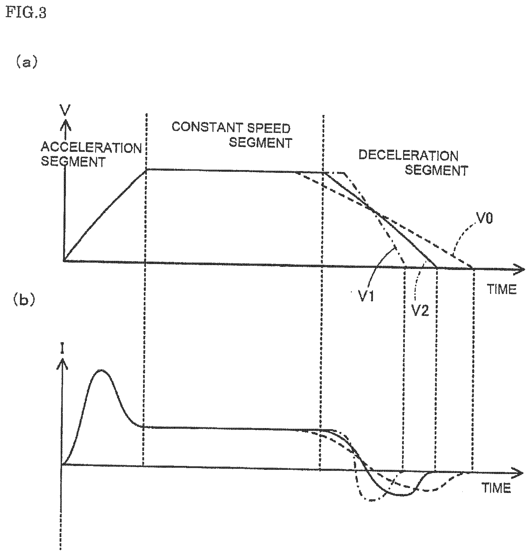

Here, Figs. 3(a) and (b) are diagrams showing a descending speed of suction nozzle 54 and a drive current of Z-axis motor 55, respectively. Fig. 3(a) shows an example of a speed command for a descending speed (V) and depicts a speed map of suction nozzle 54 when suction nozzle 54 descends from an upper standby position to a lower predetermined position (a component pickup position or a component mounting position). Fig. 3(b) is an example of a drive current (I) supplied to Z-axis motor 55 when suction nozzle 54 is lowered at a descending speed based on the speed map depicted in FIG. 3A. As shown in the figure, the descending speed is determined based on three segments including an acceleration segment where suction nozzle 54 is accelerated from a halt state to a predetermined speed, a constant speed segment where suction nozzle 54 is held at the predetermined speed, and a deceleration segment where suction nozzle 54 is decelerated from the predetermined speed. CPU 61 can change the timing at which the deceleration segment starts and a deceleration speed (a degree of deceleration) for one predetermined speed of the constant speed segment. For example, CPU 61 sets any one of three stages including a predetermined low speed pattern V0 (hereinafter, referred to as a low speed V0) in which the degree of deceleration in the deceleration segment is relatively moderate and the average speed is slow, a predetermined high speed pattern V1 (hereinafter, referred to as a high speed V1) in which the degree of deceleration is relatively steep and the average speed is fast, and a predetermined middle speed pattern V2 (hereinafter, referred to as a middle speed V2) in which the degree of deceleration is in the middle and the average speed is in the middle. Servo controller 68 derives the target speed of suction nozzles 54 based on the speed command (speed map) input from CPU 61 and the positional information inputted from encoders 57 and the like and sets a current value corresponding to the target speed. Then, servo controller 68 sets a drive signal based on the deviation between the set current value and the current value from current sensor 56 and outputs it to motor driver 69 acting as a drive circuit for Z-axis motor 55, and motor driver 69 supplies a drive current based on the drive signal to Z-axis motor 55 to drive Z-axis motor 55. This enables Z-axis motor 55 to be driven and controlled through feedback control so that suction nozzle 54 moves at the descending speed corresponding to the speed map. In this embodiment, a current value detected by current sensor 56 is also inputted into CPU 61 by way of servo controller 68. Here, when suction nozzle 54 is delayed largely from the target speed as a result of suction nozzle 54 colliding with a component or board S or the occurrence of something abnormal, a large drive current is supplied to Z-axis motor 55. Due to this, CPU 61 can detect from the current value from current sensor 56 that suction nozzle 54 has collided with the component or board S or something abnormal has happened.

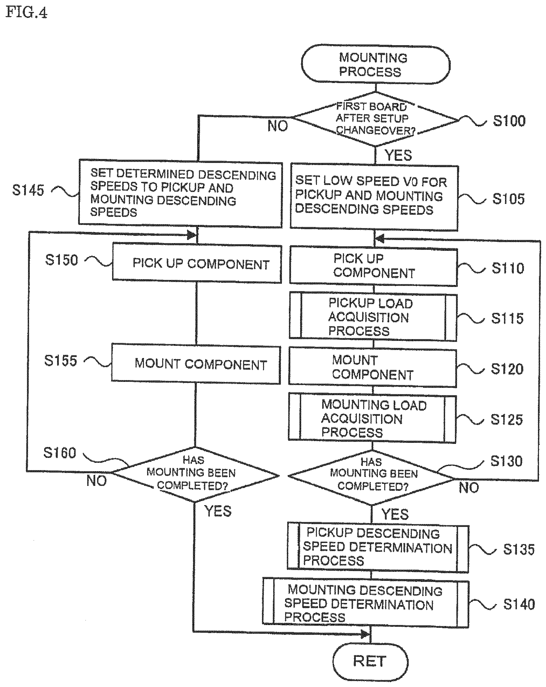

Hereinafter, an operation of mounting device 10 configured as described heretofore will be described. Fig. 4 is a flowchart illustrating an example of a mounting process. This process is executed by control device 60 in such a state that board S that is conveyed by board conveyance unit 20 is clamped and is backed up by backup unit 30.

In the mounting process illustrated in Fig. 4, CPU 61 of control device 60 first determines whether the mounting process in this time is a mounting process that is to be executed on a first (1st) board S after a setup changeover (preparation for operation) for boards S of a production type to be newly produced (S100). If CPU 61 determines that the mounting process is a mounting process to be executed on the first board S after the setup changeover, CPU 61 sets the predetermined low speed V0 for descending speeds at which suction nozzle 54 is lowered for picking up and mounting a component (S105). Here, the predetermined low speed V0 is the speed pattern in which the deceleration in the deceleration segment is moderate as described above, and at this speed the impact at the time of picking up or mounting is further suppressed. CPU 61 sets predetermined speeds for the acceleration in the acceleration segment and the predetermined speed in the constant speed segment.

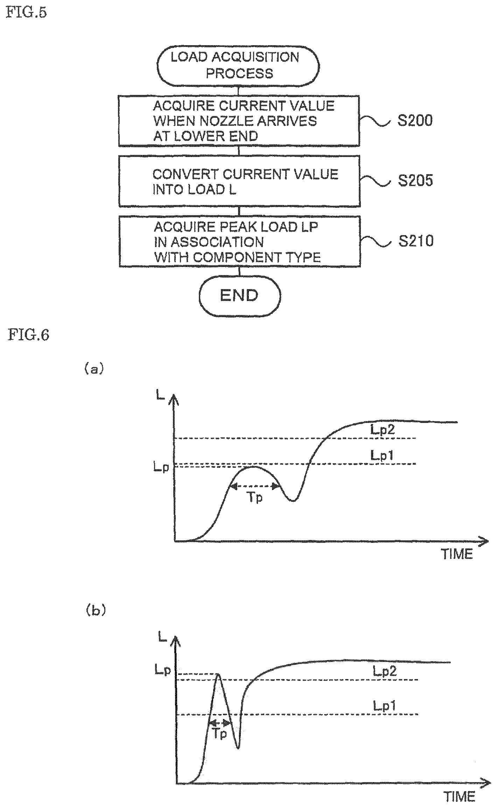

Then, CPU 61 controls mounting head 52 so that suction nozzle 54 descends at the descending speed at which the speed in the deceleration segment becomes the predetermined low speed V0 to pick up a component supplied to the supply position with component supply unit 40 (S110). Further, CPU 61 executes a pickup load acquisition process for acquiring a load applied to suction nozzle 54 when suction nozzle 54 picks up a component in the supply position (S115). Further, when suction nozzle 54 completes the picking up of the component, CPU 61 controls mounting head 52 so that mounting head 52 is moved above board S by head moving mechanism 58 and suction nozzle 54 descends at the descending speed at which the speed in the deceleration segment becomes the predetermined low speed V0 to mount the component in the mounting position on board S (S120). CPU 61 also executes a mounting load acquisition process for acquiring a load applied to suction nozzle 54 when suction nozzle 54 mounts a component (S125). Then, CPU 61 determines whether required components have been mounted on first board S (S130), and when CPU 61 determines that the mounting of the required components has not yet been completed, the mounting process returns to S110, where the processes in S110 to S125 are repeated. Due to this, CPU 61 executes the pickup load acquisition process every time suction nozzle 54 picks up a component and executes the mounting load acquisition process every time suction nozzle 54 mounts a component during the mounting process for mounting the required components on the first board S. Details of these load acquisition processes will be described later. When CPU 61 determines in S130 that the mounting of the required components on the first board S has been completed, CPU 61 not only executes a pickup descending speed determination process (S135) but also executes a mounting descending speed determination process (S140) and ends the mounting process. Here, CPU 61 of this embodiment executes the pickup load acquisition process in S115 and the mounting load acquisition process in S125 in a common process. Fig. 5 is a flowchart illustrating an example of the load acquisition process.

In the load acquisition process in FIG. 5, CPU 61 acquires a current value of a drive current supplied to Z-axis motor 55 when suction nozzle 54 arrives at the lower end (a lower predetermined position) when picking up or mounting a component (S200) and converts the acquired current value one by one into load L applied to suction nozzle 54 or the component (S205). As described above, the current values from current sensor 56 used for feedback control of Z-axis motor 55 are also inputted into CPU 61. Due to this, in S200, CPU 61 need only acquire the current value of current sensor 56 that is inputted after suction nozzle 54 enters the deceleration segment, for example. In this embodiment, the relationship between the current value of Z-axis motor 55 and the load L is obtained in advance through experiments or the like and is then stored in HDD 63 or the like as a map, not shown. CPU 61 converts a current value into load L based on the map in S205. This map can be stored for each type of suction nozzle 54. Then, CPU 61 acquires peak load Lp that constitutes a peak of the converted load L in association with the type of component (S210) and ends the load acquisition process. In S210, CPU 61 acquires peak load Lp as pickup peak load Lp in association with the type of pickup target component if the current process is the pickup load acquisition process in S115 and acquires peak load Lp as mounting peak load Lp in association with the type of mounting target component if the current process is the mounting load acquisition process in S125.

Here, Figs. 6(a) and (b) are explanatory diagrams illustrating an example of a change in the load L. As shown in the figures, load L generated when suction nozzle 54 picks up or mounts a component rises drastically as a result of suction nozzle 54 colliding with the component or colliding with board S via the component, then decreases temporarily, thereafter increases again as a result of suction nozzle 54 pressing on the component when picking up the component or the component being pressed on board S when mounting the component on board S, and then shifts at a substantially constant value. CPU 61 acquires a value at the peak of the rise of load L, which is an impact at the time of collision, as the peak load Lp. Fig. 6(a) shows a case where the peak load Lp is relatively low, and Fig. 6(b) shows a case where the peak load Lp is relatively high. This difference in peak load Lp is caused by a difference in rigidity of components or boards S. A peak time Tp of the peak load Lp (for example, a time of full width at half maximum) resulting when the peak load Lp is high becomes shorter than that resulting when the peak load Lp is low, as illustrated in the figures. That is, the peak load Lp is increased as a result of a large impact force being applied to suction nozzle 54 momentarily.

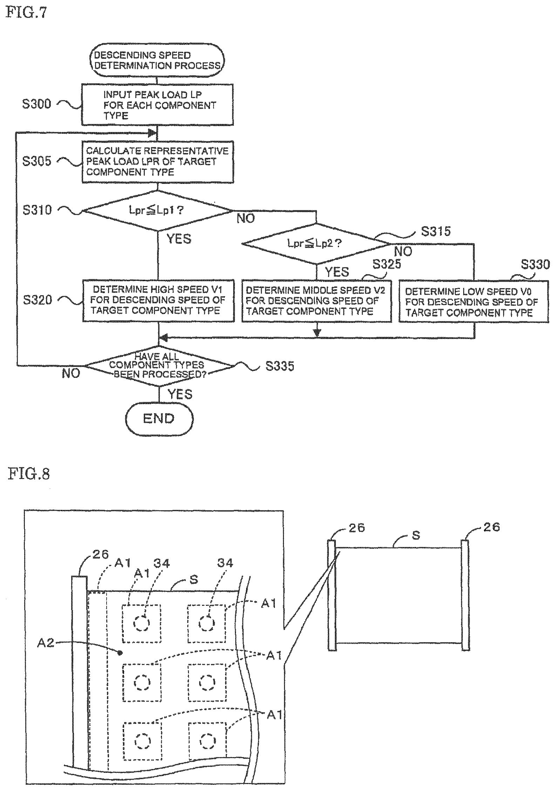

CPU 61 of this embodiment executes the pickup descending speed determination process in S135 and the mounting descending speed determination process in S140 in a common process. Fig. 7 is a flowchart illustrating an example of the descending speed determination process. In the descending speed determination process in Fig. 7, CPU 61 reads out and inputs the respective peak loads Lp of the components of different types from the peak loads Lp acquired in the load acquisition process from HDD 63 while distinguishing between the pickup peak loads Lp and the mounting peak loads Lp (S300). That is, when the current process is the pickup descending speed determination process in S135, CPU 61 inputs the respective pickup peak loads Lp of the components of different types, and when the current process is the mounting descending speed determination process in S140, CPU 61 inputs the respective mounting peak loads Lp of the components of different types. Next, CPU 61 calculates a representative peak load Lpr of each type of target component for the current process (S305). In S305, CPU 61 calculates a mean, a maximum, a mode, and the like of the peak load Lp for each component type as representative values.

Following this, CPU 61 determines whether representative peak load Lpr is equal to or smaller than first threshold Lp1 (S310) and also determines whether representative load Lpr is equal to or smaller than second threshold Lp2 (S315). If CPU 61 determines that representative peak load Lpr is equal to or smaller than first threshold Lp1, CPU 61 sets predetermined high speed V1 that is faster than predetermined low speed V0 as a descending speed for the type of target component (S320). If CPU 61 determines that representative peak load Lpr is greater than first threshold Lp1 and is equal to or smaller than second threshold Lp2, CPU 61 sets predetermined middle speed V2 that is faster than predetermined low speed V0 and is slower than predetermined high speed V1 as a descending speed for the type of target component (S325). On the other hand, if CPU 61 determines that representative peak load Lpr is greater than second threshold Lp2, CPU 61 sets predetermined low speed V0 as a descending speed for the type of the target component because an impact force that would be generated becomes relatively great, leading to a possibility of the target component being damaged (S330). When peak load Lp in Fig. 6(a) becomes representative peak load Lpr, predetermined high speed V1 is set as a descending speed, whereas when peak load Lp in Fig. 6(b) becomes representative peak load Lpr, predetermined low speed V0 is determined as a descending speed. In this way, first threshold Lp1 and second threshold Lp2 are used to determine an appropriate descending speed from the magnitude of an impact force (representative peak load Lpr) that would be generated when suction nozzle 54 is lowered at predetermined low speed V0.

When determining the pickup descending speed or the mounting descending speed in the way described above, CPU 61 determines whether the processing of all the types of components has been completed (S335), and if CPU 61 determines that the processing of all the types of components has not yet been completed, the descending speed determination process returns to S305, and the processes in S305 to S330 for determining a descending speed are executed on the type of the next target component. Then, if CPU 61 determines that the processing of all the types of components has been completed, CPU 61 ends the descending speed determination process. In this embodiment, as described above, the highest speed in the speeds that can suppress the impact force to the acceptable level is determined as the pickup and mounting descending speeds for the types of components that are mounted on the current type of board based on the load L (peak load Lp) acquired when the components are mounted on first board S after the setup changeover.

The description of the mounting process in Fig. 4 will be resumed. If CPU 61 determines in S100 that board S is not first board S after the setup changeover, the CPU 61 sets the pickup descending speed and the mounting descending speed that are determined in S135, S140, respectively, in the first mounting process after the setup changeover as pickup and mounting descending speeds, respectively (S145). Next, CPU 61 controls mounting head 52 so that suction nozzle 54 descends at the set pickup descending speed to pick up a component supplied to the supply position (S150). Additionally, CPU 61 controls mounting head 52 so that suction nozzle 54 descends at the set mounting descending speed to mount the component in the mounting position on board S (S155). Then, CPU 61 determines whether the mounting of components on board S has been completed (S160), and if CPU 61 determines that the mounting of components has not yet been completed, CPU 61 returns to S150 to repeat the process, whereas if CPU 61 determines that the mounting of components has been completed, CPU 61 ends the mounting. Since the pickup and mounting descending speeds set in S145 are determined to be the speeds that are fast but can suppress the impact force to the acceptable level based on the load L acquired when the components are mounted on first board S, the pickup and mounting of the components can be performed with good efficiency while preventing the components from being damaged to thereby improve production efficiency.

Here, the correspondence relationship between the constituent elements of this embodiment and the constituent elements of the present invention will be clarified. Z-axis motor 55 of this embodiment corresponds to the motor of the present invention, suction nozzle 54 corresponds to the pickup member, mounting device 10 corresponds to the mounting device, current sensor 56 acquiring the current value of Z-axis motor 55 corresponds to the detection section, control unit 60 that executes the processes in S115, S125 in the mounting process in Fig. 4 (the load acquisition process in Fig. 5) corresponds to the acquisition section, and control unit 60 that executes the processes in S135, S140 in the mounting process in Fig. 4 (the descending speed determination process in Fig. 7) corresponds the determination section. In this embodiment, a mounting method of the present invention is also clarified by describing the operation of mounting device 10.

In mounting device 10 described heretofore, the load L (the peak load Lp) generated when suction nozzle 54 comes into contact with a component supplied to the supply position and the load L (the peak load Lp) generated when suction nozzle 54 that holds the component picked up comes into contact with board S via the component after suction nozzle 54 descends to the mounting position of the component are acquired based on the current value of Z-axis motor 55 that is detected by the feedback control. Then, the pickup descending speed is determined based on the representative peak load Lpr of the pickup peak load Lp, and the mounting descending speed is determined based on the representative peak load Lpr of the mounting peak load Lp. As a result, the descending speeds of suction nozzle 54 can be determined by using the current value of Z-axis motor 55 that is detected by the feedback control without providing a dedicated sensor configured to detect a load L.

Further, in mounting device 10, since predetermined low speed V0 is set as the descending speed until the descending speed is determined from the representative peak load Lpr, the impact force that would otherwise be generated when suction nozzle 54 comes into contact with the component or board S until the descending speed is determined. Further, mounting device 10 acquires load L (peak load Lp) by lowering suction nozzle 54 at predetermined low speed V0, and when representative peak load Lpr is low, mounting device 10 determines descending speed so that the descending speed tends to be faster compared with a case where representative load Lpr is high. This enables suction nozzle 54 to be lowered quickly while suppressing the impact force, thereby improving the production efficiency. Further, since mounting device 10 acquires loads L (peak loads Lp) in association with types of components and determines descending speeds for those types of components, suction nozzle 54 can be lowered at appropriate descending speeds corresponding to different rigidities for each type of component.

The present invention can be carried out in various forms as long as they fall within the technical scope of the appended claims.

For example, in the embodiment described above, the descending speed is determined based on the load L acquired in the first mounting process of the board S after the setup changeover, but the present invention is not limited thereto. For example, the descending speed may be determined based on loads L acquired in the mounting process of multiple boards S after the setup changeover, or the descending speed may be determined based on loads L acquired halfway through the mounting process of the first board S. In the latter case, a descending speed for subsequent pickup operations need only be determined based on loads L acquired when picking up some of the components, or a descending speed for subsequent mounting operations need only be determined based on loads L acquired when mounting some of the components.

In the embodiment described above, the pickup descending speed is determined based on the load L acquired when picking up the component, and the mounting descending speed is determined based on the load L acquired when mounting the component, but the present invention is not limited thereto. For example, not only the pickup descending speed but also the mounting descending speed may be determined based on the load L acquired when picking up the component. Conversely, not only the mounting descending speed but also the pickup descending speed may be determined based on the load L acquired when mounting the component.

In the embodiment described above, the three-stage speed patterns of the low speed V0, the high speed V1, and the middle speed V 2 are exemplified as the speed of the deceleration segment, but the present invention is not limited thereto, and a speed pattern of multiple stages of four or more stages may be adopted, or a variably continuous speed pattern according to the load L may be adopted. Alternatively, a speed other than the low speed V0 may be determined as an initial descending speed before a descending speed is determined.

In the embodiment described above, the speeds whose degrees of deceleration are different are determined as the descending speeds in the deceleration segments, but the present invention is not limited thereto, and different descending speeds may be determined by changing speeds of other segments such as a speed in a constant speed segment.

In the embodiment described above, the descending speed is determined based on the representative peak load Lpr which is a representative value of the peak load Lp of the load L, but the present invention is not limited thereto. For example, the frequency of the peak load Lp may be obtained from the peak time Tp of the peak load Lp, and the descending speed may be determined based on a representative frequency which is a representative value of the frequency.

In the embodiment described above, the load L is acquired by converting the drive current supplied to Z-axis motor 55 into the current value detected by current sensor 56, but the present invention is not limited thereto as long as the load L is acquired by using the drive state of Z-axis motor 55 necessary for the feedback control (for example, the position of the rotation angle or the like, the rotation speed, the torque, or the like).

In the embodiment described above, the descending speed is determined for each component type for all the components, but the present invention is not limited to this. For example, a descending speed may be determined for each group of component types such as a descending speed for each component type for some components such as those having a low strength and hence likely to fail easily or precision components, and a common descending speed for other components such as those having a high strength and hence difficult to fail or general-purpose components irrespective of types of the components. Alternatively, a common descending speed may be determined for all types of components without taking types of components into consideration. As this occurs, a descending speed is determined according to an impact force (a load L) based on a difference in rigidity between types of components.

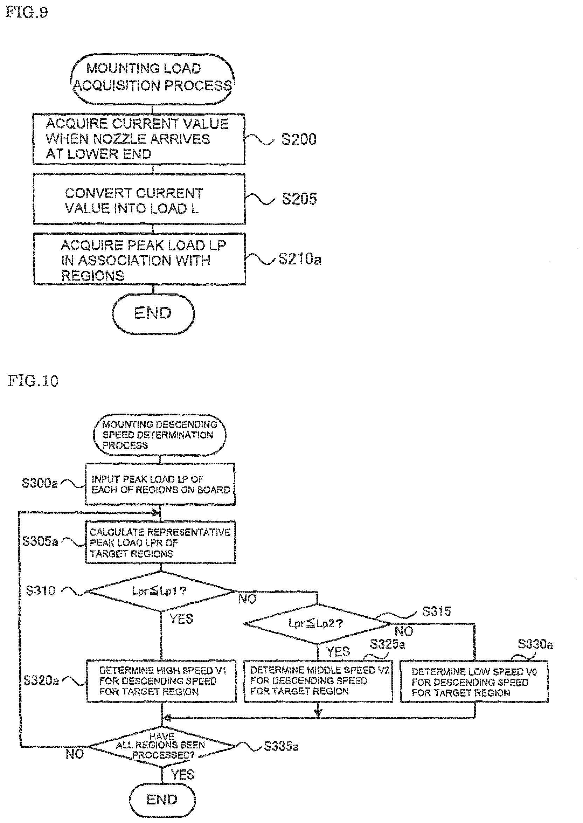

In the present invention, the descending speed is determined taking regions (component mounting positions) of board S into consideration. Fig. 8 is a diagram illustrating an example of divided regions on board S, Fig. 9 is a flowchart illustrating a mounting load acquisition and Fig. 10 is a flowchart illustrating a mounting descending speed determination process according to the invention.

As described above, since board S is held between the clamper and fastening sections 26 to be clamped and is backed up by backup pins 34, board S hardly deflects in regions near where board S is clamped and regions near where board S is backed up including regions residing on backup pins 34, whereas board S becomes easy to deflect in other regions than those regions. In this way, since the rigidity of board S differs depending on the regions on even one board S, an impact force applied to a component when it is mounted differs. Then, as illustrated in Fig. 8, regions of board S are divided into first regions A1, which are regions near where board S is clamped and where board S is backed up, and second regions A2, which are remaining regions other than the first regions, and mounting loads L are acquired. The regions near where board S is clamped and the regions near where board S is backed up may be divided further. Further, regions of board S may be divided according to characteristics of board S irrespective of whether the resulting regions lie near where board S is clamped or backed up.

In a mounting load acquisition process illustrated in Fig. 9, when converting a current value into load L in S205, CPU 61 acquires peak loads Lp which are associated with the regions of board S (S210a) and ends the process. That is, the CPU 61 acquires peak load Lp in association with either first area A1 or second region A2. In a mounting descending speed determination process illustrated in FIG. 10, CPU 61 receives peak load Lp for each region of board S (S300a) and calculates representative peak load Lpr of process target regions based on peak loads Lp associated with the process target regions (S305a). Then, if representative peak load Lpr is first threshold Lp1 or smaller, CPU 61 determines predetermined high speed V1 as a descending speed for the target regions (S320a), whereas if representative peak load Lpr exceeds first threshold Lp1 and becomes second threshold Lp2 or smaller, CPU 61 determines predetermined middle speed V2 as a descending speed for the target regions (S325a), and if representative peak load Lpr exceeds second threshold Lp2, CPU 61 determines predetermined low speed V0 as a descending speed for the target region (S330a). In this way, since mounting device 10 of the invention acquires loads L (peak loads Lp) in association with the regions of board S and determines the mounting descending speeds for the regions of board S, suction nozzle 54 is allowed to descend at the descending speeds appropriate to the different rigidities of the regions of board S to execute the mounting process. Loads L (peak loads Lp) may be obtained for the regions of board S and types of components so that mounting descending speeds are determined for the regions of board S and the types of components.

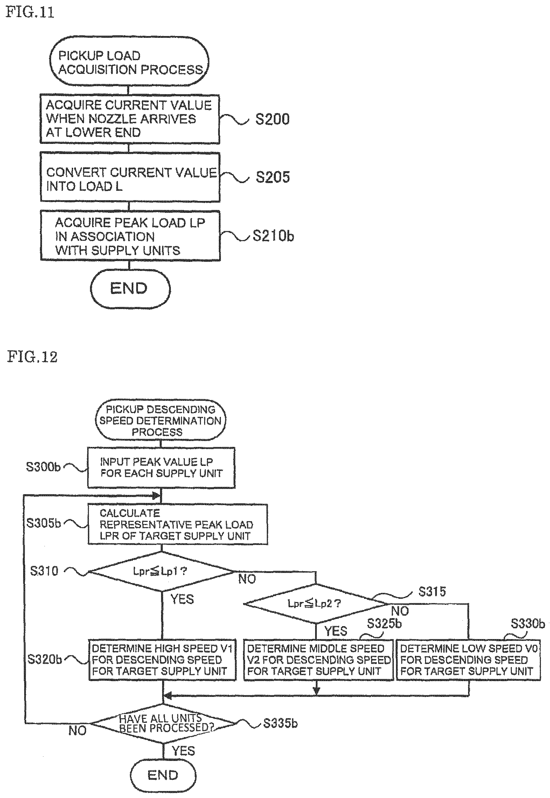

In the embodiment, the descending speeds are determined without taking the difference in type of supply units into consideration, but descending speeds may be determined by taking the difference in type of supply units into consideration. A modified example will be described in which descending speeds are determined by taking the difference in type of supply units into consideration. Fig. 11 is a flowchart illustrating a pickup load acquisition process according to the modified example, and Fig. 12 is a flowchart illustrating a pickup descending speed determination process according to the modified example.

Here, in the embodiment described above, the component supply unit 40 includes feeder unit 42 and tray unit 44. As described above, in feeder unit 42, components are accommodated in the accommodating sections of the bottom tape formed of paper or the like, and in tray unit 44, components are placed on the tray formed of resin. Due to this, since the rigidities of the portions where the components are stored differ between feeder unit 42 and tray unit 44, the impact forces come to differ when suction nozzle 54 comes into contact with the components in the supply positions on feeder unit 42 and tray unit 44.

In the pickup load acquisition process illustrated in Fig. 11, when converting a current value into load L in S205, CPU 61 acquires peak load Lp in association with the type of supply unit (S210b) and ends the process. That is, CPU 61 acquires peak load Lp in association with either feeder unit 42 or tray unit 44. In the pickup descending speed determination process illustrated in Fig. 12, CPU 61 receives input of peak loads Lp for each supply unit (S300b) and calculates representative peak load Lpr of a process target unit based on individual peak loads Lp associated with the target unit (S305b). Then, if representative peak value Lpr is first threshold Lp1 or smaller, CPU 61 determines predetermined high speed V1 as a descending speed for the target unit (S320b), whereas if representative peak load Lpr exceeds first threshold Lp1 and becomes second threshold Lp2 or smaller, CPU 61 determines predetermined middle speed V2 as a descending speed for the target unit (S325b), and if representative peak value Lpr exceeds second threshold Lp2, CPU 61 determines predetermined low speed V0 as a descending speed for the target unit (S330b). In this way, with mounting device 10 of this modified example, since loads L (peak loads Lp) are acquired in association with the types of the supply units of component supply unit 40, that is, the supply methods of components and descending speeds are determined for the respective types of the supply units, suction nozzle 54 is allowed to descend at the descending speeds appropriate to the rigidities of the different types of supply units to execute a pickup process. In this modified example, loads L (peak loads Lp) may be acquired for the respective types of supply units of component supply unit 40 and the types of components, and pickup descending speeds may be determined for the respective types of supply units and the types of components.

### Industrial applicability

The present invention can be applied to a mounting device for mounting a component on a board.

### Reference Signs List

10 mounting device, 20 board conveyance unit, 22 side frame, 24 conveyor belt, 26 fastening section, 30 backup unit, 32 backup plate, 34 backup pin, 40 component supply unit, 42 feeder unit, 44 tray unit, 50 mounting unit, 52 mounting head, 54 suction nozzle, 55 Z-axis motor, 56 current sensor, 57 encoder, 58 head moving mechanism, 60 control device, 61 CPU, 62 ROM, 63 HDD, 64 RAM, 65 input/output interface, 66 bus, 68 servo controller, 69 motor driver, A1 first region, A2 second region, S board.

## Claims

1. A mounting device (10), including a pickup member (54) configured to be lifted or lowered by driving a motor (55) with feedback control to pick up a component, which is configured to mount on a board the component picked up by the pickup member (54), the mounting device (10) comprising:
a detection section (56) configured to detect a driving state of the motor (55) necessary for the feedback control;
an acquisition section (60) configured to acquire, based on the driving state detected by the detection section (56), at least one of a load resulting when the pickup member (54) descends to a supply position of a pickup target component to come into contact with the component and a load resulting when the pickup member (54) descends to a mounting position of the component in a picked-up state to come into contact with the board via the component, and
a determination section (60) configured to determine, based on the load acquired by the acquisition section (60), at least one of a descending speed of the pickup member (54) when descending to the supply position and a descending speed of the pickup member (54) when descending to the mounting position, **characterized in that**
the acquisition section (60) is configured to acquire the load in association with multiple regions of the board, and
the determination section (60) is configured to determine the descending speed when descending to the mounting position for each of the multiple regions.

2. The mounting device according to claim 1,
wherein, until the determination section (60) determines the descending speed, the pickup member (54) is lowered at a predetermined low speed,
wherein the acquisition section (60) is configured to acquire the load based on the driving state when the pickup member (54) is lowered at the predetermined low speed, and
wherein the determination section (60) is configured to determine the descending speed to be faster than the predetermined low speed in a case where the load acquired by the acquisition section (60) is low in comparison with a case where the load is high.

3. The mounting device according to claim 1 or 2, wherein the acquisition section (60) is configured to acquire the load in association with the type of component, and
the determination section (60) is configured to determine the descending speed for each type of component.

4. The mounting device according to any one of claims 1 to 3, comprising multiple types of supply devices having different supply methods of supplying the component,
wherein the acquisition section (60) is configured to acquire the load in association with the types of the supply devices, and
wherein the determination section (60) is configured to determine the descending speed when descending to the supply position for each of the types of the supply devices.

5. A mounting method for mounting a component on a board using a pickup member (54) configured to be lifted or lowered by driving a motor (55) with feedback control to pick up the component, comprising:
(a) a step of acquiring, based on a driving state of the motor (55) detected in the feedback control; at least one of a load resulting when the pickup member (54) descends to a supply position of a pickup target component to come into contact with the pickup target component and a load resulting when the pickup member (54) descends to a mounting position of the component in a picked up state to come into contact with the board via the component, and
(b) a step of determining, based on the load acquired in the step (a), at least one of a descending speed of the pickup member (54) when descending to the supply position and a descending speed of the pickup member (54) when descending to the mounting position, **characterized in that**
the load is acquired in association with multiple regions of the board, and
the descending speed is determined when descending to the mounting position for each of the multiple regions.

## Patentansprüche

1. Montagevorrichtung (10), die ein Aufnehmer-Element (54) enthält, das so ausgeführt ist, dass es mittels Antreiben eines Motors (55) mit Rückführregelung angehoben oder abgesenkt wird, um ein Bauteil aufzunehmen, und die zum Montieren des von dem Aufnehmer-Element (54) aufgenommenen Bauteils auf einer Platine ausgeführt ist , wobei die Montagevorrichtung (10) umfasst:
einen Feststellungs-Teilabschnitt (56), der so ausgeführt ist, dass er einen Antriebszustand des Motors (55) feststellt, der für die Rückführregelung erforderlich ist;
einen Erfassungs-Teilabschnitt (60), der so ausgeführt ist, dass er auf Basis des durch den Feststellungs-Teilabschnitt (56) festgestellten Antriebszustandes eine Last, die sich ergibt, wenn sich das Aufnehmer-Element (54) an eine Zuführ-Position eines für Aufnahme bestimmten Bauteils absenkt und mit dem Bauteil in Kontakt kommt, oder/und eine Last, die sich ergibt, wenn sich das Aufnehmer-Element (54) an eine Montage-Position des Bauteils in einem aufgenommenen Zustand absenkt und über das Bauteil in Kontakt mit der Platine kommt, erfasst, sowie einen Bestimmungs-Teilabschnitt (60), der so ausgeführt ist, dass er auf Basis der von dem Erfassungs-Teilabschnitt (60) erfassten Last eine Absenkgeschwindigkeit des Aufnehmer-Elementes (54) beim Absenken an die Zuführ-Position oder/und eine Absenkgeschwindigkeit des Aufnehmer-Elementes (54) beim Absenken an die Montage-Position bestimmt, **dadurch gekennzeichnet, dass**
der Erfassungs-Teilabschnitt (60) so ausgeführt ist, dass er die Last in Verbindung mit mehreren Bereichen der Platine erfasst, und
der Bestimmungs-Teilabschnitt (60) so ausgeführt ist, dass er die Absenkgeschwindigkeit beim Absenken an die Montage-Position für jeden der mehreren Bereiche bestimmt.

2. Montagevorrichtung nach Anspruch 1,
wobei, bis der Bestimmungs-Teilabschnitt (60) die Absenkgeschwindigkeit bestimmt, das Aufnehmer-Element (54) mit einer vorgegebenen niedrigen Geschwindigkeit abgesenkt wird,
der Erfassungs-Teilabschnitt (60) so ausgeführt ist, dass er die Last auf Basis des Antriebszustandes erfasst, wenn das Aufnehmer-Element (54) mit der vorgegebenen niedrigen Geschwindigkeit abgesenkt wird, und
der Bestimmungs-Teilabschnitt (60) so ausgeführt ist, dass er, in einem Fall, in dem die durch den Erfassungs-Teilabschnitt (60) erfasste Last niedrig ist, die Absenkgeschwindigkeit so bestimmt, dass sie höher ist als in einem Fall, in dem die Last hoch ist.

3. Montagevorrichtung nach Anspruch 1 oder 2, wobei der Erfassungs-Teilabschnitt (60) so ausgeführt ist, dass er die Last in Verbindung mit dem Typ des Bauteils erfasst, und
der Bestimmungs-Teilabschnitt (60) so ausgeführt ist, dass er die Absenkgeschwindigkeit für jeden Typ Bauteil bestimmt.

4. Montagevorrichtung nach einem der Ansprüche 1 bis 3, die mehrere Typen von Zuführvorrichtungen mit unterschiedlichen Zuführverfahren zum Zuführen des Bauteils umfasst,
wobei der Erfassungs-Teilabschnitt (60) so ausgeführt ist, dass er die Last in Verbindung mit den Typen der Zuführvorrichtungen erfasst, und
der Bestimmungs-Teilabschnitt (60) so ausgeführt ist, dass er die Absenkgeschwindigkeit beim Absenken an die Zuführ-Position für jeden der Typen der Zuführvorrichtungen bestimmt.

5. Montageverfahren zum Montieren eines Bauteils auf einer Platine unter Verwendung eines Aufnehmer-Elementes (54), das so ausgeführt ist, dass es mittels Antreiben eines Motors (55) mit Rückführregelung angehoben oder abgesenkt wird, um das Bauteil aufzunehmen, wobei es umfasst:
(a) einen Schritt, in dem auf Basis eines bei der Rückführregelung festgestellten Antriebszustandes des Motors (55) eine Last, die sich ergibt, wenn sich das Aufnehmer-Element (54) an eine Zuführ-Position eines für Aufnahme bestimmten Bauteils absenkt und mit dem Bauteil in Kontakt kommt, oder/und eine Last, die sich ergibt, wenn sich das Aufnehmer-Element (54) an eine Montage-Position des Bauteils in einem aufgenommenen Zustand absenkt und über das Bauteil in Kontakt mit der Platine kommt, erfasst wird/werden, sowie
(b) einen Schritt, in dem auf Basis der in dem Schritt (a) erfassten Last eine Absenkgeschwindigkeit des Aufnehmer-Elementes (54) beim Absenken an die Zuführ-Position oder/und eine Absenkgeschwindigkeit des Aufnehmer-Elementes (54) beim Absenken an die Montage-Position bestimmt wird/werden, **dadurch gekennzeichnet, dass**
die Last in Verbindung mit mehreren Bereichen der Platine erfasst wird, und
die Absenkgeschwindigkeit beim Absenken an die Montage-Position für jeden der mehreren Bereiche bestimmt wird.

## Revendications

1. Dispositif de montage (10), comprenant un élément de saisie (54) configuré pour être levé ou abaissé en commandant un moteur (55) avec un contrôle de rétroaction pour saisir un composant, qui est configuré pour monter sur un circuit le composant saisi par l'élément de saisie (54), le dispositif de montage (10) comprenant :
une section de détection (56) configurée pour détecter un état de commande du moteur (55) nécessaire pour le contrôle de rétroaction ;
une section d'acquisition (60) configurée pour acquérir, sur base de l'état de commande détecté par la section de détection (56), au moins une charge parmi une charge apparaissant quand l'élément de saisie (54) descend jusqu'à une position d'alimentation d'un composant cible de saisie pour venir en contact avec le composant, et une charge apparaissant quand l'élément de saisie (54) descend jusqu'à une position de montage du composant dans un état saisi pour venir en contact avec le circuit via le composant, et
une section de détermination (60) configurée pour déterminer, sur base de la charge acquise par la section d'acquisition (60), au moins une vitesse parmi une vitesse de descente de l'élément de saisie (54) lors de la descente jusqu'à la position d'alimentation, et une vitesse de descente de l'élément de saisie (54) lors de la descente jusqu'à la position de montage,
**caractérisé en ce que**
la section d'acquisition (60) est configurée pour acquérir la charge en association avec de multiples régions du circuit, et
la section de détermination (60) est configurée pour déterminer la vitesse de descente lors de la descente jusqu'à la position de montage pour chacune des multiples régions.

2. Dispositif de montage selon la revendication 1,
dans lequel, jusqu'à ce que la section de détermination (60) détermine la vitesse de descente, l'élément de saisie (54) est abaissé à une basse vitesse prédéterminée,
dans lequel la section d'acquisition (60) est configurée pour acquérir la charge sur base de l'état de commande quand l'élément de saisie (54) est abaissé à la basse vitesse prédéterminée, et
dans lequel la section de détermination (60) est configurée pour déterminer la vitesse de descente comme étant supérieure à la basse vitesse prédéterminée dans le cas où la charge acquise par la section d'acquisition (60) est basse par rapport au cas où la charge est élevée.

3. Disposition de montage selon la revendication 1 ou 2, dans lequel la section d'acquisition (60) est configurée pour acquérir la charge en association avec le type de composant, et
la section de détermination (60) est configurée pour déterminer la vitesse de descente pour chaque type de composant.

4. Dispositif de montage selon l'une quelconque des revendications 1 à 3, comprenant de multiples types de dispositifs d'alimentation ayant différents procédés d'alimentation pour alimenter le composant,
dans lequel la section d'acquisition (60) est configurée pour acquérir la charge en association avec les types de dispositifs d'alimentation, et
dans lequel la section de détermination (60) est configurée pour déterminer la vitesse de descente lors de la descente jusqu'à la position d'alimentation pour chacun des types des dispositifs d'alimentation.

5. Procédé de montage pour monter un composant sur un circuit en utilisant un élément de saisie (54) configuré pour être levé ou abaissé en commandant un moteur (55) avec un contrôle de rétroaction pour saisir le composant, comprenant :
(a) une étape d'acquisition, sur base d'un état de commande du moteur (55) détecté dans le contrôle de rétroaction, d'au moins une charge parmi une charge apparaissant quand l'élément de saisie (54) descend jusqu'à une position d'alimentation d'un composant cible de saisie pour venir en contact avec le composant cible de saisie, et une charge apparaissant quand l'élément de saisie (54) descend jusqu'à une position de montage du composant dans un état saisi pour venir en contact avec le circuit via le composant, et
(b) une étape de détermination, sur base de la charge acquise à l'étape (a), d'au moins une vitesse parmi une vitesse de descente de l'élément de saisie (54) lors de la descente jusqu'à la position d'alimentation, et une vitesse de descente de l'élément de saisie (54) lors de la descente jusqu'à la position de montage,
**caractérisé en ce que**
la charge est acquise en association avec de multiples régions du circuit, et
la vitesse de descente est déterminée lors de la descente jusqu'à la position de montage pour chacune des multiples régions.
